# EUROPÄISCHE PATENTANMELDUNG

(11) **EP 1 152 247 A2**
(43) Veröffentlichungstag der Anmeldung: **07.11.2001**
(21) Anmeldenummer: 01440097.2
(22) Anmeldetag: 06.04.2001
(51) Int. Cl.: G01R 25/00

(54) **Mehrphasendetektor**

(30) Priorität: 05.05.2000 DE 10022025
(71) Anmelder: ALCATEL, 75008 Paris (FR)
(72) Erfinder: Telefont, Heinz, 3500 Krems, Egelsee (AT)
(74) Vertreter: Menzietti, Domenico, Dipl.-Ing

(57) **Zusammenfassung**

Die Erfindung betrifft einen Mehrphasendetektor zur Ermittlung des Phasenwinkels zwischen zwei Leitungsströmen (J und K). Um einen möglichst einfachen Aufbau, bei dem Transformatoren und Abgleichvorgänge entbehrlich sind, zu realisieren und gleichzeitig einen sehr weiten Strombereich abzudecken, ist vorgesehen, dass die Leitungsströme (J und K) Dioden (1) zugeführt sind, deren Spannungsabfall jeweils über Optokoppler (2) an die Eingänge eines Differenzverstärkers (3) gelegt ist, wobei das Wechselspannungs-Ausgangssignal (C) des Differenzverstärkers (3) ein Maß für den Phasenwinkel bildet.

## Beschreibung

Die Erfindung betrifft einen Mehrphasendetektor zur Ermittlung des Phasenwinkels zwischen zwei Leitungsströmen. Derartige Mehrphasendetektoren werden für diverse Anwendungen, beispielsweise zur Ansteuerung und Überwachung von Weichenantrieben, benötigt. Bekannt ist ein Phasenvergleicher, bei dem die Phasenlage von zwei Leitungsströmen durch einen Transformator und nachfolgender Auswerteelektronik erkannt wird. Die Verwendung eines Transformators ist dabei als problematisch anzusehen, da dieser teuer, schwer und toleranzbehaftet ist. Nachteilig ist außerdem, dass die Auswerteelektronik angepasst, d.h. abgeglichen werden muss. Darüber hinaus eignen sich transformatorbasierende Phasenvergleicher nur für einen relativ geringen Strombereich.

Der Erfindung liegt die Aufgabe zugrunde, einen Mehrphasendetektor der oben angegebenen Gattung anzugeben, bei dem ein Transformator sowie komplizierte und zeitraubende Abgleichvorgänge entbehrlich sind. Des weiteren ist anzustreben, dass die Phasenlage zweier Ströme potentialfrei innerhalb eines sehr großen Strombereiches, vorzugsweise 100 mA bis 100 A, gemessen und ausgewertet werden kann.

Die Aufgabe wird erfindungsgemäß durch die kennzeichnenden Merkmale des Patentanspruchs 1 gelöst. Durch die Optokopplung wird der von der Stromgröße unabhängige Spannungsabfall an den Leistungsdioden zu einer Messelektronik übertragen. Auf diese Weise lässt sich der Phasenwinkel zwischen jeweils zwei Leitungsströmen transformatorlos und innerhalb eines sehr großen Strombereiches ermitteln. Der Strom pro Phase erzeugt an den Leistungsdioden einen geringen Spannungsabfall, wodurch sich auch bei sehr unterschiedlichen Stromgrößen nur eine geringe Verlustleistung ergibt. Mittels der nachfolgenden Optokoppler wird nicht die Stromgröße, sondern der vom Phasenstrom unabhängige Spannungsabfall an den Leistungsdioden übertragen. Durch die Optokoppler sind die Phasenströme gegeneinander und von der Messelektronik getrennt. Die Phasenmessung wird durch den Differenzverstärker realisiert, wobei nur bei ungleichphasigen Eingangsströmen ein Wechselspannungs-Ausgangssignal entsteht.

Gemäß Anspruch 2 wird dieses Wechselspannungs-Ausgangssignal in eine einfacher interpretierbare Gleichspannung umgewandelt. Dazu dient eine Reihenschaltung aus Vollwellengleichrichter und Tiefpass.

In einer weiteren Ausbaustufe wird diese noch wellige Gleichspannung mit einer Referenzspannung verglichen, so dass ein digitales Ausgangssignal entsteht, welches über einen weiteren Optokoppler zur noch einfacheren Interpretation zur Verfügung steht. Das Ansprechen der Phasenerkennung, d.h. die Größenordnung des noch zu erkennenden Phasenwinkels ist durch unterschiedliche Referenzspannungen einstellbar. Bei Phasenunterschied oder beim Fehlen einer der Eingangsströme wird ein digitales Ausgangssignal aktiviert, während bei Phasengleichheit oder bei stromlosen Leitungsadern kein Ausgangssignal entsteht. Ein besonderer Vorteil des erfindungsgemäßen Mehrphasendetektors besteht darin, dass ein Abgleich der Elektronik zur Messwertaufbereitung an keiner Stelle notwendig ist.

Die Erfindung wird nachfolgend anhand zweier figürlicher Darstellung, die sich auf ein Ausführungsbeispiel beziehen, näher erläutert. Es zeigen:
- Fig. 1: ein Blockschaltbild eines Mehrphasendetektors und
- Fig. 2: Signalverläufe an bestimmten, in Fig. 1 gekennzeichneten Stellen.

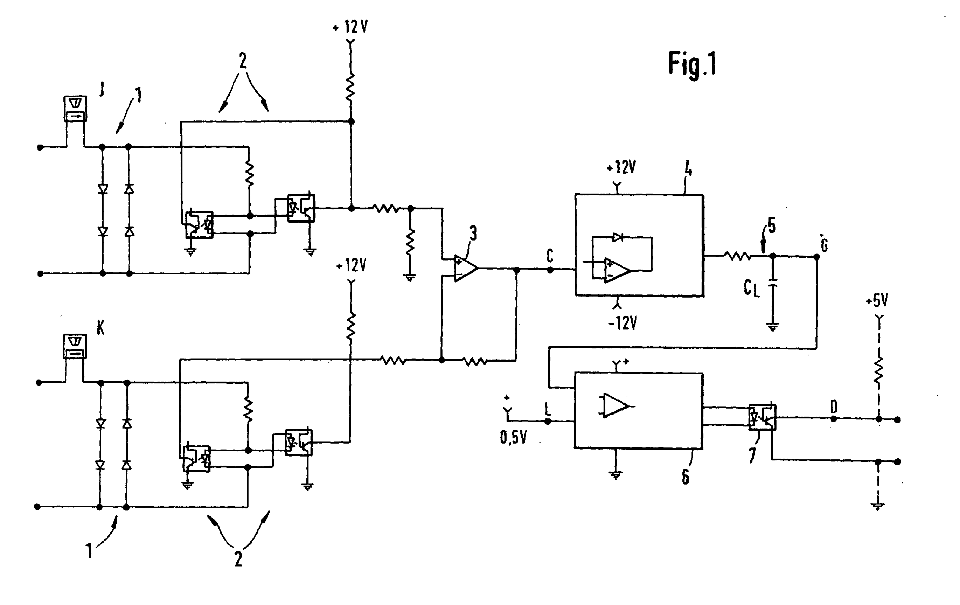

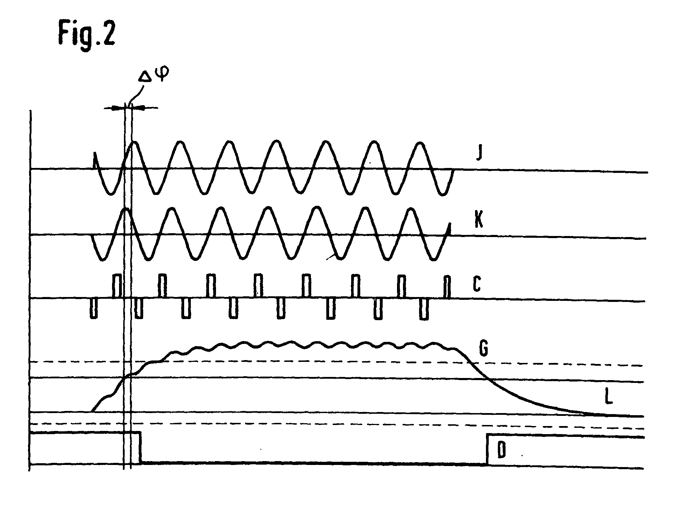

Die Schaltung gemäß Fig. 1 dient dem Zweck, festzustellen, ob zwischen zwei Leitungsströmen J und K eine Phasendifferenz vorhanden ist. Wie aus den Signalverläufen für J und K in Fig. 2 ersichtlich, ist bei dem Ausführungsbeispiel eine Phasendifferenz Δϕ vorhanden. Die beiden zu vergleichenden 50 Hz-Leitungsströme J und K werden über Leistungsdioden 1 und Optokoppler 2 an die Eingänge eines Differenzverstärkers 3 weitergeleitet. An den Leistungsdioden 1 verursachen die Leitungsströme J und K einen relativ stromunabhängigen Spannungsabfall von ca. 1,6 bis 2 V. Dieser Spannungsabfall - und nicht die Stromgröße - wird durch die nachfolgenden Optokoppler 2 übertragen. Die Optokoppler 2 bewirken dabei eine Potentialtrennung der Phasenströme gegeneinander und zur nachfolgenden Messelektronik. Am Ausgang des Differenzverstärkers 3 entsteht nur bei ungleichphasigen Leitungsströmen J und K ein Wechselspannungs-Ausgangssignal C. Dieses wird mittels eines Vollwellengleichrichters 4 und eines Tiefpasses 5 in eine der Phasendifferenz Δϕ entsprechende Gleichspannung G umgewandelt. Ein nachfolgender Spannungskomparator 6 vergleicht diese Gleichspannung G mit einer Referenzspannung L und gibt das resultierende digitale Ausgangssignal über einen weiteren Optokoppler 7 an eine nicht dargestellte Auswerteschaltung weiter. Das zur Auswertung anstehende Signal D charakterisiert durch High- oder Low-Pegel das Vorhandensein oder Nichtvorhandensein einer Phasenverschiebung Δϕ.

Die Erfindung beschränkt sich nicht auf das vorstehend angegebene Ausführungsbeispiel. Vielmehr ist eine Anzahl von Varianten denkbar, welche auch bei grundsätzlich andersgearteter Ausführung von den Merkmalen der Erfindung Gebrauch machen.

## Patentansprüche

1. Mehrphasendetektor zur Ermittlung des Phasenwinkels zwischen zwei Leitungsströmen (J und K),
**dadurch gekennzeichnet,**
**dass** die Leitungsströme (J und K) Dioden (1) zugeführt sind, deren Spannungsabfall jeweils über Optokoppler (2) an die Eingänge eines Differenzverstärkers (3) gelegt ist, wobei das Wechselspannungs-Ausgangssignal (C) des Differenzverstärkers (3) ein Maß für den Phasenwinkel bildet.

2. Mehrphasendetektor nach Anspruch 1,
**dadurch gekennzeichnet, dass** das Wechselspannungs-Ausgangssignal (C) über einen Vollwellengleichrichter (4) einem Tiefpass (5) zugeführt ist, an dessen Ausgang eine der Phasenverschiebung (Δϕ) entsprechende Gleichspannung (G) resultiert.

3. Mehrphasendetektor nach Anspruch 2,
**dadurch gekennzeichnet, dass** die Gleichspannung (G) und eine Referenzspannung (L) einem Spannungskomparator (6) zugeführt sind, dessen digitales Ausgangssignal über einen Optokoppler (7) einer Auswerteschaltung zugeführt ist.

4. Mehrphasendetektor nach einem der vorangehenden Ansprüche, **gekennzeichnet durch** Verwendung in einem Weichenmodul zur Ansteuerung und Überwachung von Weichenantrieben.
